(19)

**Europäisches Patentamt**
**European Patent Office**
**Office européen des brevets**

(11) **EP 3 901 699 A1**

(12) **EUROPEAN PATENT APPLICATION**
published in accordance with Art. 153(4) EPC

(43) Date of publication:
27.10.2021 Bulletin 2021/43

(21) Application number: 19900953.1

(22) Date of filing: 16.10.2019

(51) Int Cl.:
*G03F 7/027* (2006.01)          *C08F 2/44* (2006.01)
*C08F 2/50* (2006.01)          *G03F 7/004* (2006.01)
*H05K 3/28* (2006.01)

(86) International application number:
**PCT/JP2019/040684**

(87) International publication number:
**WO 2020/129381 (25.06.2020 Gazette 2020/26)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: 19.12.2018 JP 2018236998

(71) Applicant: **Taiyo Ink Mfg. Co., Ltd.**
**Hiki-gun, Saitama 355-0215 (JP)**

(72) Inventors:
• **CHA Haneul**
  **Hiki-gun, Saitama 355-0215 (JP)**
• **FUKUDA Shinichiro**
  **Hiki-gun, Saitama 355-0215 (JP)**
• **NAKAI Koshin**
  **Hiki-gun, Saitama 355-0215 (JP)**
• **SHIINA Touko**
  **Hiki-gun, Saitama 355-0215 (JP)**

(74) Representative: **Hoffmann Eitle**
**Patent- und Rechtsanwälte PartmbB**
**Arabellastraße 30**
**81925 München (DE)**

(54) **CURABLE RESIN COMPOSITION, DRY FILM, CURED ARTICLE, AND ELECTRONIC COMPONENT**

(57)    There is provided a curable resin composition in which it is easy for bubbles generated in a film of the curable resin composition applied on a substrate to escape and which is excellent in heat resistance, dryability, electroless gold platability, flexibility and bendability. The curable resin composition contains (A) an alkali-soluble resin, (B) a photopolymerization initiator, (C) a compound having a molecular weight of 300 to 1,000 and two ethylenically unsaturated groups, and (D) a thermosetting component. The viscosity variation of the curable resin composition is not more than 20 when 0.2 ml of the curable resin composition is interposed between two stainless steel sensor plates of 35 mm in diameter and left at 25°C for 60 seconds, and then the shear stress is varied from 0.0001 Pa to 1.0E+4 Pa.

EP 3 901 699 A1

**Description**

Technical Field

The present invention relates to a curable resin composition, a dry film thereof, a cured material of these, and an electronic component having the cured material.

Background Art

Printed wiring boards have a solder resist formed on a base material having a conductor layer of a circuit pattern. Various curable resin compositions have conventionally been proposed as, not limited to such solder resists, interlayer insulating materials of printed wiring boards and materials of permanent protective films of cover lays and the like of flexible printed wiring boards. Among the various curable resin compositions, in consideration of the environmental problem, there is widely adopted an alkali-developable curable resin composition using a dilute alkali aqueous solution as a developing solution (for example, Patent Document 1).

Prior Art Document

Patent Document

Patent Document: 1 JP-A-2014-156583

Summary of Invention

Problem to be solved by the Invention

Such a curable resin composition is applied on a substrate and thereafter cured with light and/or heat etc., but bubbles are generated in a film in the state after the application in some cases. In order to remove the bubbles present in the film, the applied composition needs to be left until the bubbles escape out of the film. However, depending on kinds of the curable resin composition to be used and circuit patterns of substrates to be applied, bubbles hardly escape and easily remain in some cases. In particular, in recent years, in order to produce printed wiring boards for high-voltage circuits, circuit patterns are formed in larger thicknesses than conventionally and along therewith, the thickness of solder resists needs to be formed in large thicknesses, but the real situation is that the larger the thicknesses of applied films of curable resin compositions, the more time the escaping outside of the bubbles generated in the films takes, reducing the production efficiency. When a curable resin composition is cured with bubbles remaining, there is a fear that there arise problems of infiltration or the like of a given chemical or plating solution.

In order to make it easy for bubbles to escape, there is such a measure to simply decrease the viscosity of the curable resin composition. However, simply decreasing the viscosity may possibly impair functions originally required for the curable resin composition (heat resistance, dryability, electroless gold platability, flexibility and the like). On the other hand, the curable resin composition is also required to be excellent in bendability, which is required for flexible substrates, whose development is actively being carried out in recent years.

Therefore, an object of the present invention is to provide a curable resin composition in which it is easy for bubbles generated in a film of the curable resin composition applied on a substrate to escape and which is excellent in heat resistance, dryability, electroless gold platability, flexibility and bendability.

Means for Solving the Problem

The above object can be achieved by a curable resin composition comprising (A) an alkali-soluble resin, (B) a photopolymerization initiator, (C) a compound having a molecular weight of 300 to 1,000 and two ethylenically unsaturated groups, and (D) a thermosetting component, wherein the viscosity variation of the curable resin composition is not more than 20 Pa when measured with 0.2 ml of the curable resin composition being interposed between two stainless steel sensor plates of 35 mm in diameter and being left at 25°C for 60 seconds, followed by application of the shear stress varied from 0.0001 Pa to 1.0E+4 Pa.

It is preferable that the (D) thermosetting component comprises a crystalline epoxy compound.

It is preferable that the (D) thermosetting component further comprises a noncrystalline epoxy resin.

It is preferable that the (C) compound having a molecular weight of 300 to 1,000 and two ethylenically unsaturated groups has a viscosity of 15 to 200 mPa·s at 25°C.

It is preferable that the content of the (C) compound having a molecular weight of 300 to 1,000 and two ethylenically unsaturated groups is, in terms of solid content, 5 to 40 parts by mass with respect to 100 parts by mass of the (A) alkali-soluble resin.

It is preferable that the curable resin composition is used for production of a printed wiring board with a high-voltage circuit.

The dry film of the present invention comprises a resin layer prepared by applying any one of the above curable resin compositions on a film and drying the curable resin composition.

The cured material of the present invention is obtained by curing any one of the above curable resin compositions or the dry film.

The electronic component of the present invention comprises the cured material.

Effects of Invention

According to the present invention, there can be provided a curable resin composition in which it is easy for bubbles generated in a film of the curable resin composition applied on a substrate to escape and which is excellent in heat resistance, dryability, electroless gold platability, flexibility and bendability. Therefore, it is enabled to provide a cured material high in the quality and the reliability of the curable resin composition, and an electronic component having the cured material.

Mode for carrying out the Invention

Hereinafter, the present invention will be described in detail. As described above, the curable resin composition of the present invention comprises (A) an alkali-soluble resin, (B) a photopolymerization initiator, (C) a compound having a molecular weight of 300 to 1,000 and two ethylenically unsaturated groups, and (D) a thermosetting component, wherein the viscosity variation of the curable resin composition is not more than 20 Pa when measured with 0.2 ml of the curable resin composition being interposed between two stainless steel sensor plates of 35 mm in diameter and being left at 25°C for 60 seconds, followed by application of the shear stress, the shear stress being varied from 0.0001 Pa to 1.0E+4 Pa. The present inventors have found that by making the curable resin composition to contain the above predetermined components and to have a viscosity variation defined in the above of as low as not more than 20 Pa, the object of the present invention can be achieved. Hereinafter, the each component will be described in detail.

[(A) Alkali-soluble resin]

The alkali-soluble resin contains one or more functional groups of a phenolic hydroxyl group, a thiol group and a carboxyl group, and is a resin soluble to an alkali solution, and preferably examples thereof include compounds having two or more phenolic hydroxyl groups, carboxyl group-containing resins, compounds having a phenolic hydroxyl group and a carboxyl group, and compounds having two or more thiol groups. As the alkali-soluble resin, a carboxyl group-containing resin or a phenolic hydroxyl group-containing resin can be used, but a carboxyl group-containing resin is preferable.

The carboxyl group-containing resin is a component which is polymerized or crosslinked to be cured by light irradiation, and can be made to be alkali-developable due to containing a carboxyl group. From the viewpoint of photocurability and development resistance, it is preferable that the carboxyl group-containing resin has, in addition to the carboxyl group, an ethylenically unsaturated bond in its molecule. However, only a carboxyl group-containing resin having no ethylenically unsaturated double bond may be used. As the ethylenically unsaturated bond, preferable is one derived from acrylic acid or methacrylic acid or derivatives thereof. Among the carboxyl group-containing resins, preferable are carboxyl group-containing resins having a copolymerization structure, carboxyl group-containing resins having a urethane structure, carboxyl group-containing resins using an epoxy resin as their starting raw material, and carboxyl group-containing resins using a phenol compound as their starting raw material. Specific examples of the carboxyl group-containing resins include compounds (either of oligomers and polymers) listed below.

(1) A carboxyl group-containing photosensitive resin obtained by reacting an epoxy resin having a functionality of two or more with (meth)acrylic acid, and adding a dibasic acid anhydride such as phthalic anhydride, tetrahydrophthalic anhydride or hexahydrophthalic anhydride to hydroxyl groups present on the side chains. Here, the epoxy resin having a functionality of two or more is preferably of a solid state.

(2) A carboxyl group-containing photosensitive resin obtained by reacting a polyfunctional epoxy resin, which has been prepared by further epoxidizing a hydroxyl group in a bifunctional epoxy resin with epichlorohydrin, with (meth)acrylic acid, and adding a dibasic acid anhydride to the resultant hydroxyl group. Here, the bifunctional epoxy resin is preferably solid.

(3) A carboxyl group-containing photosensitive resin obtained by reacting an epoxy compound having two or more epoxy groups in one molecule thereof with a compound having at least one alcoholic hydroxyl group and one phenolic hydroxyl group in one molecule thereof and an unsaturated group-containing monocarboxylic acid such as (meth)acrylic acid, and reacting alcoholic hydroxyl groups of the resultant reaction product with a polybasic acid anhydride such as maleic anhydride, tetrahydrophthalic anhydride, trimellitic anhydride, pyromellitic anhydride or adipic anhydride.

(4) A carboxyl group-containing photosensitive resin obtained by reacting a compound having two or more phenolic hydroxyl groups in one molecule thereof, such as bisphenol A, bisphenol F, bisphenol S, a novolac phenol resin, a poly-p-hydroxystyrene, a condensation product of naphtol with an aldehyde, or a condensation product of dihydroxynaphthalene with an aldehyde with an alkylene oxide such as ethylene oxide or propylene oxide, to obtain a reaction product, and reacting the obtained reaction product with an unsaturated group-containing monocarboxylic acid such as (meth)acrylic acid to obtain a reaction product, and reacting the obtained reaction product with a polybasic acid anhydride.

(5) A carboxyl group-containing photosensitive resin obtained by reacting a compound having two or more phenolic hydroxyl groups in one molecule thereof with a cyclic carbonate compound such as ethylene carbonate or propylene carbonate to obtain a reaction product, reacting the obtained reaction product with an unsaturated group-containing monocarboxylic acid to obtain a reaction product, and reacting the obtained reaction product with a polybasic acid anhydride.

(6) A terminal carboxyl group-containing urethane resin obtained by subjecting a diisocyanate compound such as an aliphatic diisocyanate, a branched aliphatic diisocyanate, an alicyclic diisocyanate or an aromatic diisocyanate to a polyaddition reaction with a diol compound such as a polycarbonate-based polyol, a polyether-based polyol, a polyester-based polyol, a polyolefin-based polyol, an acrylic polyol, a bisphenol A-based alkylene oxide adduct diol or a compound having a phenolic hydroxyl group and an alcoholic hydroxyl group to obtain a urethane resin, and reacting terminals of the obtained urethane resin with an acid anhydride.

(7) A terminal-(meth)acrylated carboxyl group-containing urethane resin obtained by adding a compound having one hydroxyl group and one or more (meth)acryloyl groups in one molecule thereof such as a hydroxyalkyl (meth)acrylate, during synthesis of a carboxyl group-containing urethane resin obtained by polyaddition reaction of diisocyanate with a carboxyl group-containing dialcohol compound such as dimethylolpropionic acid or dimethylolbutyric acid and a diol compound.

(8) A terminal-(meth)acrylated carboxyl group-containing urethane resin obtained by adding a compound having one isocyanate group and one or more (meth)acryloyl groups in one molecule thereof, such as an equimolecular reaction product of isophorone diisocyanate with pentaerythritol triacrylate, during synthesis of a carboxyl group-containing urethane resin obtained by polyaddition reaction of diisocyanate with a carboxyl group-containing dialcohol compound and a diol compound.

(9) A carboxyl group-containing photosensitive resin obtained by copolymerization of an unsaturated carboxylic acid such as (meth)acrylic acid with an unsaturated group-containing compound such as styrene, $\alpha$-methylstyrene, lower alkyl (meth)acrylate or isobutylene.

(10) A carboxyl group-containing photosensitive resin obtained by reacting a polyfunctional oxetane resin, which will be described below, with a dicarboxylic acid such as adipic acid, phthalic acid or hexahydrophthalic acid, adding a dibasic acid anhydride to the produced primary hydroxyl group(s) to obtain a carboxyl group-containing polyester resin, and further adding, to the obtained carboxyl group-containing polyester resin, a compound having one epoxy group and one or more (meth)acryloyl groups in one molecule thereof, such as glycidyl (meth)acrylate or $\alpha$-methylglycidyl (meth)acrylate.

(11) A carboxyl group-containing photosensitive resin obtained by adding a compound having a cyclic ether group and a (meth)acryloyl group in one molecule thereof to any one of the carboxyl group-containing resins in the above-mentioned (1) to (10).

Here, the (meth)acrylate is a generic term of acrylates, methacrylates and mixtures thereof, and the same is applied to other similar expressions below.

The acid value of the carboxyl group-containing resin is preferably 40 to 150 mgKOH/g. By making the acid value of the carboxyl group-containing resin to be 40 mgKOH/g or higher, the alkali development becomes good. Then by making the acid value to be 150 mgKOH/g or lower, normal resist pattern drawing can be made easy. More preferably, the acid value is 50 to 130 mgKOH/g.

The content of the (A) alkali-soluble resin as described above is, in a whole composition, preferably 5 to 60% by mass, more preferably 10 to 60% by mass, still more preferably 20 to 60% by mass and especially preferably 30 to 50% by mass. In the case of being 5 to 60% by mass, the coating film strength is good; the viscosity of the composition is suitable; and the applicability and the like can be improved.

[(B) Photopolymerization initiator]

As the (B) photopolymerization initiator, there may be used any one as long as being a well-known one as a photopolymerization initiator or a photo-radical generating agent.

Examples of the (B) photopolymerization initiator can include bisacylphosphine oxides such as bis-(2,6-dichlorobenzoyl)phenylphosphine oxide, bis-(2,6-dichlorobenzoyl)-2,5-dimethylphenylphosphine oxide, bis-(2,6-dichlorobenzoyl)-4-propylphenylphosphine oxide, bis-(2,6-dichlorobenzoyl)-1-naphthylphosphine oxide, bis-(2,6-dimethoxybenzoyl)phenylphosphine oxide, bis-(2,6-dimethoxybenzoyl)-2,4,4-trimethylpentylphosphine oxide, bis-(2,6-dimethoxybenzoyl)-2,5-dimethylphenylphosphine oxide and bis-(2,4,6-trimethylbenzoyl)-phenylphosphine oxide; monoacylphosphine oxides such as 2,6-dimethoxybenzoyldiphenylphosphine oxide, 2,6-dichlorobenzoyldiphenylphosphine oxide, methyl 2,4,6-trimethylbenzoylphenylphosphinate, 2-methylbenzoyldiphenylphosphine oxide, isopropyl pivaloylphenylphosphinate and 2,4,6-trimethylbenzoyldiphenylphosphine oxide (Omnirad TPO, manufactured by IGM Resins B.V.); hydroxyacetophenones such as 1-hydroxy-cyclohexyl phenyl ketone, 1-[4-(2-hydroxyethoxy)-phenyl]-2-hydroxy-2-methyl-1-propan-1-one, 2-hydroxy-1-{4-[4-(2-hydroxy-2-methyl-propionyl)-benzyl]phenyl}-2-methyl-propan-1-one and 2-hydroxy-2-methyl-1-phenylpropan-1-one; benzoines such as benzoin, benzil, benzoin methyl ether, benzoin ethyl ether, benzoin n-propyl ether, benzoin isopropyl ether and benzoin n-butyl ether; benzoin alkyl ethers; benzophenones such as benzophenone, p-methylbenzophenone, Michler's ketone, methylbenzophenone, 4,4'-dichlorobenzophenone and 4,4'-bis diethylaminobenzophenone; acetophenones such as acetophenone, 2,2-dimethoxy-2-phenylacetophenone, 2,2-diethoxy-2-phenylacetophenone, 1,1-dichloroacetophenone, 1-hydroxycyclohexyl phenyl ketone, 2-methyl-1-[4-(methylthio)phenyl]-2-morpholino-1-propanone, 2-benzyl-2-dimethylamino-1-(4-morpholinophenyl)-butanone-1,2-(dimethylamino)-2-[(4-methylphenyl)methyl]-1-[4-(4-morpholinyl)phenyl]-1-butanone and N,N-dimethylaminoacetophenone; thioxanthones such as thioxanthone, 2-ethylthioxanthone, 2-isopropylthioxanthone, 2,4-dimethylthioxanthone, 2,4-diethylthioxanthone, 2-chlorothioxanthone and 2,4-diisopropylthioxanthone; anthraquinones such as anthraquinone, chloroanthraquinone, 2-methylanthraquinone, 2-ethylanthraquinone, 2-tert-butylanthraquinone, 1-chloroanthraquinone, 2-amylanthraquinone and 2-aminoanthraquinone; ketals such as acetophenone dimethyl ketal and benzyl dimethyl ketal; benzoate esters such as ethyl-4-dimethylaminobenzoate, 2-(dimethylamino)ethyl benzoate and ethyl p-dimethylbenzoate; oxime esters such as 1,2-octanedione, 1-[4-(phenylthio)-, 2-(O-benzoyloxime)] and ethanone, 1-[9-ethyl-6-(2-methylbenzoyl)-9H-carbazol-3-yl]-, 1-(O-acetyloxime); titanocenes such as bis($\eta$5-2,4-cyclopentadien-1-yl)-bis(2,6-difluoro-3-(1H-pyrrol-1-yl)phenyl)titanium and bis(cyclopentadienyl)-bis[(2,6-difluoro-3-(2-(1-pyrr-1-yl)ethyl)phenyl)]titanium; and phenyl disulfide, 2-nitrofluorene, butyroin, anisoin ethyl ether, azobisisobutyronitrile, and tetramethylthiuram disulfide. Among these, preferable are monoacylphosphine oxides and oxime esters; and among these, more preferable are 2,4,6-trimethylbenzoyldiphenylphosphine oxide and ethanone, 1-[9-ethyl-6-(2-methylbenzoyl)-9H-carbazol-3-yl]-, 1-(O-acetyloxime). The (B) photopolymerization initiator may be used singly or in a combination of two or more.

The content of the (B) photopolymerization initiator is, with respect to 100 parts by mass of the (A) alkali-soluble resin, preferably 0.01 to 30 parts by mass and more preferably 0.01 to 20 parts by mass. When the content of the (B) photopolymerization initiator is 0.01 part by mass or larger, the photocurability on copper becomes good; it becomes difficult for a coating film to be peeled; and the coating film properties such as chemical resistance become good. On the other hand, when the content of the (B) photopolymerization initiator is 30 parts by mass or smaller, the light absorption of the (B) photopolymerization initiator becomes good and the deep curability is improved.

[(C) Compound having a molecular weight of 300 to 1,000 and two ethylenically unsaturated groups]

The curable resin composition of the present invention comprises the (C) compound having a molecular weight of 300 to 1,000 and two ethylenically unsaturated groups (hereinafter, referred to also as compound (C)) as an essential component.

Here, in the case of a compound having one ethylenically unsaturated group, it is conceivable that since the sensitivity in photocuring ends in decreasing, there decrease the finger touch dryability, the flexibility, the bendability and the like; and in the case of a compound having three or more ethylenically unsaturated groups, it ends in becoming difficult for bubbles to escape. On the other hand, in the case of a compound having two ethylenically unsaturated groups and a molecular weight of lower than 300, there decrease the finger touch dryability, the gold plating resistance, and the like; and in the case of a compound having two ethylenically unsaturated groups and a molecular weight of higher than 1,000, it ends in becoming difficult for bubbles to escape.

Therefore, the curable resin composition of the present invention needs to comprise, together with the (A) component, the (B) component and the (D) component, the (C) compound having a molecular weight of 300 to 1,000 and two ethylenically unsaturated groups.

The compound having a molecular weight of 300 to 1,000 and two ethylenically unsaturated groups may be aliphatic, aromatic, alicyclic or araliphatic; and examples thereof include: diacrylates of ethylene oxide adducts or propylene oxide adducts of glycols such as ethylene glycol, methoxytetraethylene glycol, propylene glycol, 1,3-propanediol, butanediol, pentanediol, hexanediol, heptanediol, hexanediol, octanediol, decanediol and neopentyl glycol; diacrylates of glycols such as polyethylene glycol, polypropylene glycol and polytetramethylene glycol, or ethylene oxide adducts or propylene oxide adducts of these glycols; and/or methacrylates corresponding to these acrylates. Specifically, there can be used APG-700, manufactured by Shin-Nakamura Chemical Co., Ltd., EBECRYL145, manufactured by Daicel-Allnex Ltd., A-PTMG-65, manufactured by Shin-Nakamura Chemical Co., Ltd., and the like. These can be used singly or in a combination of two or more, depending on desired properties.

The range of the molecular weight of the compound (C) is preferably 350 to 950, more preferably 350 to 900 and especially preferably 400 to 850. When the molecular weight is below 300, there cannot be secured the handleability of the curable resin composition and the viscosity thereof necessary in application; when the molecular weight exceeds 1,000, a sufficient bubble escaping property may not possibly be attained. Here, the "bubble escaping property" refers to ease of escaping of bubbles generated in the curable resin composition applied on a substrate.

The (C) compound having a molecular weight of 300 to 1,000 and two ethylenically unsaturated groups has a viscosity of, from the viewpoint of the bubble escaping property, at 25°C, preferably 15 to 200 mPa·s and especially preferably 20 to 150 mPa·s. The viscosity refers to a viscosity measured according to JIS Z8803.

The content of the (C) compound having a molecular weight of 300 to 1,000 and two ethylenically unsaturated groups is, in terms of solid content, with respect to 100 parts by mass of the (A) alkali-soluble resin, for example, in a proportion of 5 to 100 parts by mass, preferably in a proportion of 5 to 70 parts by mass and more preferably in a proportion of 5 to 40 parts by mass. When the content of the (C) compound having a molecular weight of 300 to 1,000 and two ethylenically unsaturated groups is in this range, particularly the bubble escaping property is improved and there are further improved the other properties required for the curable resin composition, such as the electroless gold platability, the heat resistance, the flexibility and the bendability. In particular, from the viewpoint of the balance between the bubble escaping property and the finger touch dryability, the lower limit value of the content of the (C) compound having a molecular weight of 300 to 1,000 and two ethylenically unsaturated groups is preferably 5 parts by mass; and the upper limit value thereof is 40 parts by mass.

[(D) Thermosetting component]

As the (D) thermosetting component contained in the photocurable thermosetting resin composition according to the present invention, there can be used a well-known common thermosetting resin such as a blocked isocyanate compound, an amino resin, a maleimide compound, a benzoxazine resin, a carbodiimide resin, a cyclocarbonate compound, a polyfunctional epoxy compound, a polyfunctional oxetane compound, an episulfide resin or a melamine derivative. Preferable thermosetting components among these are thermosetting components having two or more groups of at least one groups of cyclic ether groups and cyclic thioether groups (hereinafter, abbreviated to cyclic (thio)ether group) in their one molecule. These thermosetting components having cyclic (thio)ether groups have many commercially available kinds, and can impart diverse properties depending on their structure.

The thermosetting component having two or more cyclic (thio)ether groups in the molecule is a compound having two or more groups of either one groups or both groups of 3, 4 or 5-membered cyclic ether groups and cyclic thioether groups in their molecule; examples of the compound include compounds having at least two or more epoxy groups in their molecule, that is, polyfunctional epoxy compounds, compounds having at least two or more oxetanyl groups in their molecule, that is, polyfunctional oxetanyl compounds, and compounds having two or more thioether groups in their molecule, that is, episulfide resins.

Examples of the polyfunctional epoxy compounds include bisphenol A epoxy resins such as, (all, trade names), jER 828, jER 834, jER 1001 and jER 1004, manufactured by Mitsubishi Chemical Corp., EPICLON 840, EPICLON 850, EPICLON 1050 and EPICLON 2055, manufactured by DIC Corp., EPOTOHTO YD-011, YD-013, YD-127 and YD-128, manufactured by Nippon Steel Chemical & Material Co., Ltd., D.E.R. 317, D.E.R. 331, D.E.R. 661 and D.E.R. 664, manufactured by the Dow Chemical Co., SUMI-EPOXY ESA-011, ESA-014, ELA-115 and ELA-128, manufactured by Sumitomo Chemical Co., Ltd., and A.E.R. 330, A.E.R. 331, A.E.R. 661 and A.E.R. 664, manufactured by Asahi Kasei Corp.; brominated epoxy resins such as, (all, trade names), jER YL903, by Mitsubishi Chemical Corp., EPICLON 152 and EPICLON 165, manufactured by DIC Corp., EPOTOHTO YDB-400 and YDB-500, manufactured by Nippon Steel Chemical & Material Co., Ltd., D.E.R. 542, manufactured by the Dow Chemical Co., SUMI-EPOXY ESB-400 and ESB-700, manufactured by Sumitomo Chemical Co., Ltd., and A.E.R. 711 and A.E.R.714, manufactured by Asahi Kasei Corp.; novolac epoxy resins such as, (all, trade names), jER 152 and jER 154, manufactured by Mitsubishi Chemical Corp., D.E.N. 431 and D.E.N. 438, manufactured by the Dow Chemical Co., EPICLON N-730, EPICLON N-770 and EPICLON N-865, manufactured by DIC Corp., EPOTOHTO YDCN-701 and YDCN-704, manufactured by Nippon Steel Chemical & Material Co., Ltd., EPPN-201, EOCN-1025, EOCN-1020, EOCN-104S and RE-306, manufactured by Nippon Kayaku Co., Ltd., SUMI-EPOXY ESCN-195X and ESCN-220, manufactured by Sumitomo Chemical Co., Ltd., and A.E.R. ECN-235, and ECN-299, manufactured by Asahi Kasei Corp.; bisphenol F epoxy resins such as, (all, trade names), EPICLON 830, manufactured by DIC Corp., jER 807, manufactured by Mitsubishi Chemical Corp., EPOTOHTO YDF-170, YDF-175, and YDF-2004, manufactured by Nippon Steel Chemical & Material Co., Ltd.; hydrogenated bisphenol A epoxy resins such as, (all, trade names), EPOTOHTO ST-2004, ST-2007 and ST-3000, manufactured by Nippon Steel Chemical & Material Co., Ltd.; glycidylamine epoxy resins such as, (all, trade names), jER 604, manufactured by Mitsubishi Chemical Corp., EPOTOHTO YH-434, manufactured by Nippon Steel Chemical & Material Co., Ltd., and SUMI-EPOXY ELM-120, manufactured by Sumitomo Chemical Co., Ltd.; alicyclic epoxy resins such as, (trade name), Celloxide 2021P, manufactured by Daicel Corp.; trihydroxyphenylmethane epoxy resins such as, (all, trade names), YL-933, manufactured by Mitsubishi Chemical Corp., and T.E.N., EPPN-501, and EPPN-502, manufactured by the Dow Chemical Co.; bixylenol or biphenol epoxy resins or mixtures thereof such as, (all, trade names), YL-6056, YX-4000 and YL-6121, manufactured by Mitsubishi Chemical Corp.; bisphenol S epoxy resins such as, (all, trade names), EBPS-200, manufactured by Nippon Kayaku Co., Ltd., EPX-30, manufactured by Adeka Corp., and EXA-1514, manufactured by DIC Corp.; bisphenol A novolac epoxy resins such as, (trade name), jER 157S, manufactured by Mitsubishi Chemical Corp.; tetraphenylolethane epoxy resins such as, (trade name), jER YL-931, manufactured by Mitsubishi Chemical Corp.; heterocyclic epoxy resins such as, (trade name), TEPIC, manufactured by Nissan Chemical Corporation; diglycidyl phthalate resins such as BLEMER DDT, manufactured by NOF Corp.; tetraglycidylxylenoylethane resins such as ZX-1063, manufactured by Nippon Steel Chemical & Material Co., Ltd.; naphthalene group-containing epoxy resins such as ESN-190 and ESN-360, manufactured by Nippon Steel Chemical & Material Co., Ltd., and HP-4032, EXA-4750, EXA-4700, manufactured by DIC Corp.; epoxy resins having a dicyclopentadiene skeleton such as HP-7200, and HP-7200H, manufactured by DIC Corp.; glycidyl methacrylate copolymer epoxy resins such as CP-50S, and CP-50M, manufactured by NOF Corp.; copolymer epoxy resins of cyclohexylmaleimide and glycidyl methacrylate; epoxy-modified polybutadiene rubber derivatives (for example, Epolead PB-3600 and the like, manufactured by Daicel Corp.); and CTBN-modified epoxy resins (for example, YR-102, YR-450 and the like, manufactured by Nippon Steel Chemical & Material Co., Ltd.), but are not limited to these. These epoxy resins can be used singly or in a combination of two or more. Among these, especially preferable are novolac epoxy resins, modified novolac epoxy resins, heterocyclic epoxy resins, bixylenol epoxy resins, and epoxy resins having a dicyclopentadiene skeleton or mixtures thereof.

Examples of the polyfunctional oxetane compounds include polyfunctional oxetanes such as bis[(3-methyl-3-oxetanylmethoxy)methyl] ether, bis[(3-ethyl-3-oxetanylmethoxy)methyl] ether, 1,4-bis[(3-methyl-3-oxetanylmethoxy)methyl]benzene, 1,4-bis[(3-ethyl-3-oxetanylmethoxy)methyl]benzene, (3-methyl-3-oxetanyl)methyl acrylate, (3-ethyl-3-oxetanyl)methyl acrylate, (3-methyl-3-oxetanyl)methyl methacrylate and (3-ethyl-3-oxetanyl)methyl methacrylate, and oligomers or copolymers thereof, and besides, etherified substances of oxetane alcohols with resins having hydroxyl groups, such as novolac resins, poly(p-hydroxystyrene), cardo-type bisphenols, calixarenes, calixresorcinarenes, and silsesquioxane. Examples of the polyfunctional oxetane compounds additionally also include copolymers of an unsaturated monomer having an oxetane ring with an alkyl (meth)acrylate.

Examples of the episulfide resins having two or more cyclic thioether groups in their molecule include YL7000 (bisphenol A episulfide resin), manufactured by Mitsubishi Chemical Corp., and YSLV-120TE, manufactured by Nippon Steel Chemical & Material Co., Ltd. Episulfide resins and the like made by replacing oxygen atoms of epoxy groups of novolac epoxy resins by sulfur atoms can also be produced by the similar synthesis method and used.

In the present invention, it is preferable to use a crystalline epoxy compound as the (D) thermosetting component. Thereby, the improving effect of bubble escaping property becomes more secure. The crystalline epoxy compound means a highly crystalline epoxy resin, and refers to a thermosetting epoxy resin which, though having regularly arrayed polymer chains and being a solid resin at a temperature equal to or lower than the melting point, becomes, during melting, nearly as low in the viscosity as a liquid resin. Further, it is also preferable that in addition to the crystalline epoxy compound, a noncrystalline epoxy compound is contained. The concurrent use of the crystalline epoxy compound and the noncrystalline epoxy compound improves the dispersibility of the crystalline epoxy compound and can improve the solder heat resistance, the flexibility and the bendability. From such viewpoints, the blend ratio of the crystalline epoxy compound and the noncrystalline epoxy compound is, in mass ratio, preferably 40: 60 to 75: 25.

As the crystalline epoxy resin, there can be used a crystalline epoxy resin having a biphenyl structure, a sulfide structure, a phenylene structure, a naphthalene structure or the like. The biphenyl-type epoxy resins are provided, for example, as "jER(R) YX4000", "jER(R) YX4000H", "jER(R) YL6121H", "jER(R) YL6640" and "jER(R) YL6677", manufactured by Mitsubishi Chemical Corp.; diphenyl sulfide-type epoxy resins are provided, for example, as "EPOTOHTO(R) YSLV-120TE", manufactured by Nippon Steel Chemical & Material Co., Ltd.; the phenylene-type epoxy resins are provided, for example, as "EPOTOHTO(R) YDC-1312", manufactured by Nippon Steel Chemical & Material Co., Ltd.; and the naphthalene-type epoxy resins are provided, for example, as "EPICLON(R) HP-4032", "EPICLON(R) HP-4032D" and "EPICLON(R) HP-4700", manufactured by DIC Corp. As the crystalline epoxy resins, there can also be used "EPOTOHTO(R) YSLV-90C", manufactured by Nippon Steel Chemical & Material Co., Ltd., and "TEPIC-S"(triglycidyl isocyanurate), manufactured by Nissan Chemical Corporation. Among these, from the viewpoint of being excellent in the property of solder heat resistance, preferable is "jER(R) YX4000", manufactured by Mitsubishi Chemical Corp., which is a biphenyl-type epoxy resin. In the resin composition of the present invention, these may be used singly or concurrently in two or more.

The content of the thermosetting component is, in terms of solid content, with respect to 100 parts by mass of the (A) alkali-soluble resin, preferably 10 to 100 parts by mass. In particular, with regard to the content of the thermosetting component having two or more cyclic (thio)ether groups in the molecule, the cyclic (thio)ether group is, in terms of solid content, with respect to 1 eq of a carboxyl group of the (A) alkali-soluble resin, preferably in the range of 0.5 to 3.0 eq and more preferably 0.8 to 2.5 eq. When the content of the thermosetting component is in the above range, the heat resistance, the alkali resistance, the electric insulativeness, the strength of a cured film, and the like are good.

[Other components]

The curable resin composition of the present invention may include a defoaming agent. Examples of the defoaming agent include silicon-based defoaming agents and non-silicon-based defoaming agent, but among these, from the viewpoint of being capable of reducing contamination of a developing solution and making it difficult for adhesive defects of a silk screen ink (marking ink) to be caused, it is preferable to use a non-silicon-based defoaming agent. The defoaming agent may be used singly or in a combination of two or more.

Examples of the silicon-based defoaming agent include KS-66 (manufactured by Shin-Etsu Chemical Co., Ltd.). Examples of the non-silicon-based defoaming agent include FOAMKILLER NSI-0.00 (manufactured by Aoki Oil Industrial Co., Ltd.).

The content of the defoaming agent is, in terms of solid content, with respect to 100 parts by mass of the (A) alkali-soluble resin, preferably 0.01 to 30.00 parts by mass.

The curable resin composition of the present invention may include a colorant. Specific examples of the colorant include Phthalocyanine Blue, Phthalocyanine Green, Iodine Green, Disazo Yellow, Leuco Crystal Violet, carbon black, naphthalene black, and Solvent Blues. The colorant may be used singly or in a combination of two or more.

Then, the curable resin composition of the present invention, for the purpose of preparation of the composition, the viscosity regulation in application on a substrate or a carrier film, and the like, can contain an organic solvent. As the organic solvent, there can be used a well-known common organic solvent, including ketones such as methyl ethyl ketone and cyclohexanone; aromatic hydrocarbons such as toluene, xylene and tetramethylbenzene; glycol ethers such as cellosolve, methyl cellosolve, butyl cellosolve, carbitol, methylcarbitol, butylcarbitol, propylene glycol monomethyl ether, dipropylene glycol monomethyl ether, dipropylene glycol diethyl ether, diethylene glycol monomethyl ether acetate and tripropylene glycol monomethyl ether; esters such as ethyl acetate, butyl acetate, butyl lactate, cellosolve acetate, butyl cellosolve acetate, carbitol acetate, butylcarbitol acetate, propylene glycol monomethyl ether acetate, dipropylene glycol monomethyl ether acetate and propylene carbonate; aliphatic hydrocarbons such as octane and decane; and petroleum solvents such as petroleum ether, petroleum naphtha and solvent naphtha. These organic solvents can be used singly or in a combination of two or more.

The curable resin composition of the present invention may further include other additives well-known and common in the field of electronic materials. Examples of the other additives include thermal polymerization inhibitors, ultraviolet absorbers, silane coupling agents, plasticizers, flame retarders, antistatic agents, age resistors, antibacterial-, antifungal agents, leveling agents, thickeners, adhesiveness imparting agents, thixotropy imparting agents, photoinitiator aids, sensitizers, photobase generating agents, thermoplastic resins, elastomers, organic fillers such as urethane beads, inorganic fillers, release agents, surface treating agents, dispersants, dispersant aids, surface modifying agents, stabilizers, fluorescent substances and cellulose resins.

As described above, the viscosity variation is not more than 20 Pa when 0.2 ml of the curable resin composition of the present invention is interposed between two stainless steel sensor plates of 35 mm in diameter and left at 25°C for 60 seconds, and then the shearing stress is varied from 0.0001 Pa to 1.0E+4 Pa. Due to the small range of viscosity variation by the shear stress, the foam escaping property is improved. The above viscosity variation is more preferably 10 Pa or lower.

The curable resin composition of the present invention may be used by being made into a dry film, or in a liquid form. In the case of the use in a liquid form, the curable resin composition may be of one-pack type or two or more-pack type.

The dry film of the present invention has a resin layer prepared by applying the curable resin composition of the present invention, on a carrier film and drying the curable resin composition. When the dry film is formed, first, the curable resin composition of the present invention is diluted with an above organic solvent to be regulated to a suitable viscosity, and then applied in a uniform thickness on a carrier film by a comma coater, a blade coater, a lip coater, a rod coater, a squeeze coater, a reverse coater, a transfer roll coater, a gravure coater, a spray coater or the like. Thereafter, by drying the applied composition usually at a temperature of 50 to 130°C for 1 to 30 minutes, the resin layer can be formed. The applied film thickness is not especially limited, but generally, the film thickness after the drying is suitably selected in the range of 10 to 150 $\mu$m, preferably 20 to 60 $\mu$m.

As the carrier film, a plastic film is used, and there can be used, for example, a polyester film such as a polyethylene terephthalate (PET), a polyimide film, a polyamideimide film, a polypropylene film or a polystyrene film. The thickness of the carrier film is not especially limited, but is generally selected suitably in the range of 10 to 150 $\mu$m.

After the resin layer composed of the curable resin composition of the present invention is formed on the carrier film, for the purpose of preventing dusts from depositing on the surface of the film, it is preferable that a strippable cover film is further laminated on the surface of the film. As the strippable cover film, there can be used, for example, a polyethylene film, a polytetrafluoroethylene film, a polypropylene film, a surface-treated paper or the like. The cover film suffices if, when being stripped, exhibiting a lower adhesive force than that between the resin layer and the carrier film.

Then, in the present invention, the dry film may be prepared by applying the curable resin composition of the present invention on the above cover film and drying the curable resin composition to form the resin layer and laminating the carrier film on the surface of the resin layer. That is, when the dry film is produced in the present invention, as a film on which the curable resin composition of the present invention is to be applied, either of the carrier film and the cover film may be used.

For forming a cured material by using the curable composition of the present invention, by carrying out light exposure (light irradiation) on a resin layer obtained by applying the composition on a substrate and then evaporating and drying a solvent, light exposed portions (portions irradiated with light) are cured. Specifically, selective light exposure with active energy rays in a contact or non-contact mode through a patterned photomask, or direct pattern light exposure by a laser direct aligner is carried out, and unexposed portions are developed with an alkali aqueous solution (for example, a 0.3 to 3% by mass soda carbonate aqueous solution) to thereby form a resist pattern. The resultant is further heated at a temperature of about 100 to 180°C to thermally cure (post-cure), whereby a cured film (cured material) can be formed which is excellent in various properties such as the heat resistance, the chemical resistance, the hygroscopic resistance, the adhesiveness and the electric property.

The curable resin composition of the present invention is, for example, regulated to have a viscosity suitable to an application method by using the above organic solvent, and applied on a base material by a method such as dip coating, flow coating, roll coating, bar coating, screen printing or curtain coating, and thereafter, the organic solvent contained in the composition is evaporated and dried (temporarily dried) at the temperature of about 60 to 100°C, whereby a tack-free resin layer can be formed. In the case of a dry film prepared by applying the above composition on a carrier film or a cover film and drying the above composition and wound up as a film, a resin layer can be formed by laminating a layer of the composition of the present invention on a base material so that the layer contacts with the base material by a laminator or the like, and thereafter peeling the carrier film.

The above base material uses a material of printed wiring boards or flexible printed wiring boards having circuits previously formed of copper or the like, besides, copper clad laminates for high-frequency circuits or the like using paper phenol, paper epoxy, glass cloth epoxy, glass polyimide, glass cloth/nonwoven fabric epoxy, glass cloth/paper epoxy, synthetic fiber epoxy, fluororesin·polyethylene·polyphenylene ether, polyphenylene oxide·cyanate or the like, and examples thereof can include copper clad laminates of all grades (FR-4 and the like), besides, metal substrates, polyimide films, PET films, polyethylene naphthalate (PEN) films, glass substrates, ceramic substrates and wafer sheets.

The above volatilization drying or thermal curing can be carried out by using a hot-air circulation drying furnace, an IR furnace, a hot plate, a convection oven or the like (a method comprising countercurrent-contacting of a heated air in a dryer using one that includes a heat source in the mode of heating air by steam, and a method comprising spraying a support from a nozzle).

The aligner to be used for the above active energy ray irradiation suffices as long as being an apparatus mounted with a high-pressure mercury lamp, an extrahigh-pressure mercury lamp, a metal halide lamp, a mercury short arc lamp or the like and irradiating ultraviolet rays in the range of 350 to 450 nm, and further, a direct drawing apparatus (for example, a laser direct imaging apparatus, which draws images directly by a laser using CAD data from a computer) can also be used. A lamp light source or a laser light source of the direct drawing machine suffices if having a maximum wavelength in the range of 350 to 410 nm. The light exposure amount for image formation can be made to be, depending on the film thickness and the like, generally in the range of 20 to 1,000 $mJ/cm^2$, and preferably 20 to 800 $mJ/cm^2$.

The above developing method can use a dipping method, a shower method, a spray method, a brush method or the like; and as a developing solution, there can be used an alkali aqueous solution of potassium hydroxide, sodium hydroxide, sodium carbonate, potassium carbonate, sodium phosphate, sodium silicate, ammonia, an amine or the like.

The curable resin composition of the present invention is suitably used for forming a cured film (cured material) on printed wiring boards such as package substrates, more suitably used for forming a permanent film, still more suitably for forming a solder resist, an interlayer insulating layer and a cover lay, and especially suitably used for forming a solder resist. Further, the curable resin composition can be used suitably for forming a permanent film such as a solder resist of printed wiring boards to be exposed to a high-temperature condition in vehicular applications and the like.

The present invention also provides a cured material made by curing the curable resin composition of the present invention, and an electronic component having the cured material. By using the curable resin composition of the present invention, there is provided the electronic component high in the quality, the durability and the reliability. Here, in the present invention, the electronic component means a component to be used in electronic circuits, and includes active components such as printed wiring boards, transistors, light emitting diodes and laser diodes, and besides, passive components such as capacitors, inductors and connectors; and the cured material of the curable composition of the present invention has the advantageous effects of the present invention as an insulating cured film for these electronic components.

The curable resin composition of the present invention, since being excellent in the bubble escaping property, can be suitably used particularly in production of printed wiring boards for high-voltage circuits used for hybrid vehicles and the like. That is, as described in the paragraph of Problem to be Solved by the Invention, since circuit patterns of the printed wiring boards for high-voltage circuits are formed more thickly than circuit patterns formed on conventional printed wiring boards, in the case of applying conventional curable resin compositions, it becomes difficult for bubbles to escape in some cases, but the curable resin composition of the present invention, since being excellent in the bubble escaping property, can suitably be used in production of the printed wiring boards for high-voltage circuits. Here, in the present invention, the high-voltage refers to a voltage of 200 V or higher. The thickness of circuit patterns (formed from copper and the like) of the printed wiring boards for high-voltage circuits is, for example, 60 $\mu$m or larger, and especially 70 to 100 $\mu$m.

Examples

Hereinafter, the present invention will be described in more detail by way of Examples and Comparative Examples, but the present invention is not any more limited to Examples and Comparative Examples. Here, parts indicating contents is parts by mass unless otherwise specified.

<Preparation of compositions>

Curable resin compositions were prepared by preliminarily mixing components indicated in Table 1 by a stirrer, and thereafter kneading the resultant by a three-roll mill.

[Table 1]

| Components (parts by mass) | Product Names etc. | Example 1 | Example 2 | Example 3 | Example 4 | Example 5 | Example 6 | Comparative Example 1 | Comparative Example 2 |
|---|---|---|---|---|---|---|---|---|---|
| Carboxyl group-containing resin *1 | ZFR-1401H | 113 | 113 | 129 | 129 | 113 | 129 | 129 | 129 |
| Carboxyl group-containing resin *2 | UXE-3000 | 31 | 31 | 31 | 31 | 31 | 31 | 31 | 31 |
| Carboxyl group-containing resin *3 | Synthesis Example described below | 15 | 8 | 15 | 15 | 15 | 15 | 15 | 15 |
| Photopolymerizable Monomer *4 | APG-700 (bifunctional, molecular weight: 808) | 22 | 22 | - | - | 10 | - | - | - |
| Photopolymerizable Monomer *5 | EBECRYL 145 (bifunctional, molecular weight: 328) | - | - | - | 22 | - | 30 | - | - |
| Photopolymerizable Monomer *6 | A-PTMG-65 (bifunctional, molecular weight: 758) | - | - | 22 | - | - | - | - | - |
| Photopolymerizable Monomer *7 | A-DOD-N (bifunctional, molecular weight: 282) | - | - | - | - | - | - | - | 22 |
| Photopolymerizable Monomer *8 | A-GLY-20E (trifunctional oligomer, molecular weight: 1,295) | - | - | - | - | - | - | 22 | - |
| Crystalline Epoxy Compound *9 | YX-4000 | 24 | 15 | 35 | 24 | 24 | 24 | 24 | 12 |
| Noncrystalline Epoxy Compound *10 | HP-7200L CA85 | 12 | 12 | 12 | 12 | 12 | 12 | 12 | - |
| Noncrystalline Epoxy Compound *11 | YDF-2001 CA75 | - | - | - | - | - | - | - | 8.4 |
| Cellulose Resin *12 | CAP-504-0.2DPM30 | 25 | 25 | 25 | 25 | 25 | 25 | 25 | 25 |
| Photopolymerization Initiator *13 | JMT-784 | 0.1 | 0.1 | 0.1 | 0.1 | 0.1 | 0.1 | 0.1 | 0.1 |

(continued)

| Components (parts by mass) | Product Names etc. | Example 1 | Example 2 | Example 3 | Example 4 | Example 5 | Example 6 | Comparative Example 1 | Comparative Example 2 |
|---|---|---|---|---|---|---|---|---|---|
| Photopolymerization Initiator *14 | Omnirad 369E | 10 | 10 | 10 | 10 | 10 | 10 | 10 | 10 |
| Flame Retardant *15 | Exolit OP-935 | 50 | 50 | 50 | 50 | 50 | 50 | 50 | 50 |
| Defoaming Agent *16 | KS-66 | 3.8 | 3.8 | 3.8 | 3.8 | 3.8 | 3.8 | 3.8 | 3.8 |
| Organic Pigment (blue) | C.I.Pigment Blue 15:3 | 1.2 | 1.2 | 1.2 | 1.2 | 1.2 | 1.2 | 1.2 | 1.2 |
| Organic Pigment (yellow) | C.I.Pigment Yellow 147 | 1.2 | 1.2 | 1.2 | 1.2 | 1.2 | 1.2 | 1.2 | 1.2 |
| Solvent *17 | DPM | 14.0 | 14.0 | 15.0 | 15.0 | 14.0 | 15.0 | 6.0 | 25.0 |
| Total | | 336.4 | 320.4 | 364.4 | 353.4 | 336.4 | 353.4 | 329.4 | 332.8 |
| Evaluations | Bubble Escaping Property | ◎ | ◎ | ◎ | ◎ | ◎ | ◎ | × | Δ |
| | Finger Touch Dryability | ◎ | ◎ | ◎ | ◎ | ◎ | ◎ | Δ | × |
| | Electroless Gold Plating | ◎ | ◎ | ◎ | ◎ | ◎ | ◎ | × | × |
| | solder heat resistance | ◎ | ◎ | ◎ | ◎ | ◎ | ◎ | Δ | Δ |
| | Flexibility | ◎ | ◎ | ◎ | ◎ | ◎ | ◎ | × | × |
| | Bendability | ◎ | ◎ | ◎ | ◎ | ◎ | ◎ | × | × |
| | Flame Retardancy | ○ | ○ | ○ | ○ | ○ | ○ | ○ | ○ |
| | Electric Property | ○ | ○ | ○ | ○ | ○ | ○ | ○ | ○ |
| | Viscosity-1 | ◎ | ◎ | ◎ | ◎ | ◎ | ◎ | × | ◎ |
| | Viscosity-2 | ◎ | ◎ | ◎ | ◎ | ◎ | ◎ | × | ◎ |
| | Viscosity-3 | ◎ | ◎ | ◎ | ◎ | ◎ | ◎ | × | Δ |

<Synthesis Example>

The alkali-soluble resin *3 in Table was synthesized as follows.

[Synthesis of the alkali-soluble resin *3]

456 parts of bisphenol A, 228 parts of water and 649 parts of a 37% formalin were charged in a flask equipped with a cooling tube and a stirrer, held at a temperature of 40°C or lower, and added with 228 parts of a 25% sodium hydroxide aqueous solution; and after the finish of the addition, the resultant was allowed to react at 50°C for 10 hours. After the finish of the reaction, the resultant was cooled to 40°C, and neutralized to a pH of 4 with a 37.5% phosphoric acid aqueous solution while the temperature was held at 40°C or lower. Thereafter, the resultant was allowed to stand still and a water layer was separated. After the separation, 300 parts of methyl isobutyl ketone was added and homogeneously dissolved; thereafter, the resultant was three times washed with 500 parts of distilled water; and water, the solvent and the like were removed at a temperature of 50°C or lower under reduced pressure. An obtained polymethylol compound was dissolved in 550 parts of methanol to thereby obtain 1,230 parts of a methanol solution of the polymethylol compound.

A part of the obtained methanol solution of the polymethylol compound was dried at room temperature in a vacuum drier, and the solid content was 55.2%.

500 parts of the obtained methanol solution of the polymethylol compound, and 440 parts of 2,6-xylenol were charged in a flask equipped with a cooling tube and a stirrer, and homogeneously dissolved at 50°C. After the homogeneous dissolution, methanol was removed at a temperature of 50°C or lower under reduced pressure. Thereafter, 8 parts of oxalic acid was added, and allowed to react at 100°C for 10 hours. After the finish of the reaction, a distillate was removed at 180°C under a reduced pressure of 50 mmHg to thereby obtain 550 parts of a novolac resin A.

130 parts of the novolac resin A, 2.6 parts of a 50% sodium hydroxide aqueous solution, and 100 parts of toluene/methyl isobutyl ketone (2/1 in mass ratio) were charged in an autoclave equipped with a thermometer, a nitrogen introducing device-cum-alkylene oxide introducing device and a stirrer, and the atmosphere of the system interior was replaced by nitrogen under stirring; and the resultant was heated to raise the temperature and 60 parts of propylene oxide was little by little introduced at 150°C and 8 kg/cm$^2$ and allowed to react. The reaction was continued for about 4 hours until the gage pressure became 0.0 kg/cm$^2$, and the resultant was thereafter cooled to room temperature. 3.3 parts of a 36% hydrochloric acid aqueous solution was added to and mixed with the reaction solution to neutralize sodium hydroxide. The neutralization reaction product was diluted with toluene, washed three times with water, and subjected to solvent removal by an evaporator to thereby obtain a propylene oxide adduct of the novolac resin A having a hydroxyl value of 189 g/eq. The adduct was one in which the average amount of propylene oxide added was 1 mol per 1 eq of phenolic hydroxyl groups.

189 parts of the obtained propylene oxide adduct of the novolac resin A, 36 parts of acrylic acid, 3.0 parts of p-toluenesulfonic acid, 0.1 part of hydroquinone monomethyl ether and 140 parts of toluene were charged in a reaction vessel equipped with a stirrer, a thermometer and an air blowing tube, stirred while air was blown in, and heated to 115°C, and allowed to react further for 4 hours while water produced by the reaction was distilled away as an azeotropic mixture with toluene, and thereafter cooled to room temperature. An obtained reaction solution was washed with a 5% NaCl aqueous solution; and toluene was removed by being distilled away under reduced pressure; thereafter, diethylene glycol monoethyl ether acetate was added to thereby obtain an acrylate resin solution having a solid content of 67%.

Then, 322 parts of the obtained acrylate resin solution, 0.1 part of hydroquinone monomethyl ether and 0.3 part of triphenylphosphine were charged in a four-necked flask equipped with a stirrer and a reflux cooler; the mixture was heated at 110°C and 60 parts of tetrahydrophthalic anhydride was added and allowed to react for 4 hours; and the resultant was cooled and then taken out. A photosensitive carboxyl group-containing resin solution thus obtained had a solid content of 70% and a solid content acid value of 81 mgKOH/g. Hereinafter, this carboxyl group-containing photosensitive resin solution is called the alkali-soluble resin solution *3.

*1: a bisphenol F-type acid-modified epoxy acrylate resin (solid content: 65%), ZFR-1401H, manufactured by Nippon Kayaku Co., Ltd.

*2: a composite-type acid-modified epoxy acrylate resin (solid content: 52%), UXE-3000, manufactured by Nippon Kayaku Co., Ltd.

*3: the above synthesis example

*4: a polypropylene glycol (#700) diacrylate, viscosity: 68 mPa·s (25°C), APG-700, manufactured by Shin-Nakamura Chemical Co., Ltd.

*5: a PO-modified neopentyl glycol diacrylate, viscosity: 20 mPa·s (25°C), EBECRYL 145, manufactured by Daicel-Allnex Ltd.

*6: a polytetramethylene glycol #650 diacrylate, viscosity: 140 mPa·s (25°C), A-PTMG-65, manufactured by Shin-Nakamura Chemical Co., Ltd.

*7: 1,10-decanediol diacrylate, viscosity: 10 mPa·s (25°C), A-DOD-N, manufactured by Shin-Nakamura Chemical Co., Ltd.

*8: an ethoxylated glycerol triacrylate, A-GLY-20E, manufactured by Shin-Nakamura Chemical Co., Ltd.

*9: a biphenyl-type crystalline epoxy compound, YX-4000, manufactured by Mitsubishi Chemical Corp.

*10: a noncrystalline epoxy compound, HP-7200L CA85, manufactured by Nippon Steel Chemical & Material Co., Ltd.

*11: a noncrystalline epoxy compound, YDF-2001 CA75, manufactured by Nippon Steel Chemical & Material Co., Ltd.

*12: CAP-504-0.2DPM30, manufactured by Eastman Chemical Co.

*13: bis(η5-2,4-cyclopentadien-1-yl)-bis(2,6-difluoro-3-(1H-pyrrol-1-yl)-phenyl)titanium, JMT-784, manufactured by BASF SE

*14: 2-methyl-1-[4-(methylthio)phenyl]-2-morpholinopropan-1-one, Omnirad 369E, manufactured by IGM Resins B.V.

*15: Exolit OP-935, manufactured by Clariant Specialty chemicals Co., Ltd.

*16: a mixture of dimethicone and silicic acid, Simethicone KS-66, manufactured by Shin-Etsu Silicone Co., Ltd.

*17: dipropylene glycol methyl ether

<Condition of forming cured materials>

Drying: 80°C, 30 minutes, light exposure: DI 200mJ/cm$^2$, post-curing: 150°C, 60 minutes

<Evaluation methods>

(1) The bubble escaping property

The prepared each composition was applied on a substrate having a circuit pattern of 70 μm in Cu thickness formed thereon by a screen printing method, and left for a certain time (about 10 to 15 minutes) from right after the printing; and there was checked the decreasing ratio of the number of bubbles present between circuits in a certain area (50 mm × 50 mm) from right after the printing until after the being left.

The case where the decreasing ratio was 30% or less with respect to 100% at bubble generation was taken as ×; the case of more than 30% and 50% or less, as Δ; the case of more than 50% and 70% or less, as ○; and the case of more than 70% and 90% or less, as ◎.

(2) The finger touch dryability

The above each composition was applied on the whole surface of a patterned copper foil substrate by a screen printing method, dried in a hot-air circulation drying furnace at 80°C for 30 minutes, and thereafter photocured; a PET film was pressed on the photocured substrate; and after 60 seconds, the sticking state of the negative film when the film was stripped off was evaluated.

The case where when the film was stripped off, there was resistance and the coating film was peeled off was taken as ×; the case where when the film was stripped off, there was resistance and marks clearly remained on the coating film, as Δ; the case where when the film was stripped off, there was no resistance at all, but slight marks remained on the coating film was taken as ○; and the case where when the film was stripped off, there was no resistance at all, and no marks remained on the coating film was taken as ◎.

(3) Electroless gold plating

The each composition of Examples and Comparative Examples was applied and cured on a substrate using a PI base material and having a circuit pattern of 70 μm in Cu thickness under the above substrate fabrication condition, and the resultant was subjected to electroless gold plating treatment giving 3.00 μm or larger of Ni and 0.030 μm or larger of Au; and film peeling in a tape peel test was evaluated.

The case where there were five or more peeled portions was taken as ×; three or four portions, as Δ; one or two portions, as ○; and the case where no peeling was observed was taken as ◎.

(4) Solder heat resistance

The each composition of Examples and Comparative Examples was applied and cured on a substrate using a PI base material and having a circuit pattern of 70 μm in Cu thickness under the above substrate fabrication condition, and the resultant was coated with an IPA flux and dipped in a solder bath at 288°C three times for 10 seconds; thereafter, a tape peel test was carried out on the resultant, and film peeling was evaluated.

The case where there were five or more peeled or swollen portions was taken as ×; three or four portions, as Δ; one or two portions, as ○; and the case where no peeling was observed was taken as ◎.

(5) Flexibility

The each composition of Examples and Comparative Examples was applied under the above substrate fabrication condition so that the film thickness became 50 ± 5 μm, and the cured film was peeled from the base material; and the resultant was subjected to a tensile test at a tensile rate of 1 mm/min by using a tensile testing machine; and the elongation percentage when the specimen was cut (broken) was calculated by the following expression and the flexibility was evaluated.

*

$$\texttt{Tensile elongation (\%) = 100} \times \texttt{(L - Lo)/Lo}$$

*Lo: the specimen length before test, L: the specimen length at break

The case where the tensile elongation was 3% or lower was taken as ×: higher than 3% and 5% or lower, as Δ: higher than 5% and 10% or lower, as ○: and higher than 10%, as ◎.

(6) The bendability

The each composition of Examples and Comparative Examples was applied on a PI base material by a screen printing method so that the film thickness became 20 μm, and dried and photocured in the above light exposure amount; and thereafter, by bending the photocured sample into a 3-inch cylinder or folding the sample by 180°, whether or not the surface was peeled off was evaluated.

The case where the entire surface was peeled off was taken as ×: the case where the surface was partially peeled off was taken as Δ: and the case where no peeling was observed was taken as ○.

(7) The flame retardancy

Each film test piece (200 ± 5 × 50 ± 1 × t mm) applied and cured on a PI base material under the above condition was cylindrically wound, and attached vertically on a clamp; and a 20-mm flame was applied two times for 3 seconds to the test piece and there was carried out judgment of whether the flame retardancy was VTM-0, VTM-1, VTM-2 or Not indicated in the following Table by the burning behavior.

The case where the flame retardancy was VTM-2 was taken as ×; VTM-1, as Δ; and VTM-0, as ○.

[Table 2]

| Evaluation of Flame Retardancy UL94 VTM | | | |
|---|---|---|---|
| Test Criteria | VTM-0 | VTM-1 | VTM-2 |
| Burning time of each individual specimen (second) | ≤ 10 | ≤ 30 | ≤ 30 |
| (after first and second flame applications) | | | |
| Total Burning Time (second) | ≤ 50 | ≤ 250 | ≤ 250 |
| (Flame applications of 10 times) | | | |
| Burning and afterglow after second flame application (second) | ≤ 30 | ≤ 60 | ≤ 60 |
| Dripping of burning specimen (ignition of cotton batting) | none | none | present |
| Burning up to holding clamp (complete burning of specimen) | none | none | none |

(8) The electric property

The each composition of Examples and Comparative Examples was applied and cured on an FP4 base material under the above condition so that the film thickness became 50 ± 5 μm; and voltage was applied thereto by using a withstand voltage tester and the voltage when the insulativeness was lost was measured.

The case where the insulativeness was lost at 3.0 kV or lower was taken as ×; at higher than 3.0 kV and 4.0 kV or lower, as Δ; and at higher than 4.0 kV and 5.0 kV or lower, as ○.

(9) The viscosity-1

The viscosity at room temperature in a 5-rpm rotation of the each composition of Examples and Comparative Examples was evaluated by a cone plate-type viscometer.

The case where the viscosity exceeded 150 mPa·s was taken as ×; 150 to 120 mPa·s, as Δ; lower than 120 mPa·s and 100 mPa·s or higher, as ◎; and lower than 100 mPa·s and 70 mPa·s or higher, as Δ.

(10) The viscosity -2

The viscosity at room temperature in a 5-rpm rotation and the viscosity at room temperature in a 50-rpm rotation were measured by the cone plate-type viscometer, respectively, by the same method as in the viscosity-1, and the comparative thixotropic value (5 rpm/50 rpm) was evaluated.

The case where the comparative thixotropic value was 1.5 or higher was taken as ×; 1.3 or higher and lower than 1.5, as Δ; and 1.1 or higher and lower than 1.3, as ◎.

(11) The viscosity-3

The each composition was interposed between an upper plate being a 35 mm-diameter 1°-angle stainless steel sensor plate and a lower plate being a 35 mm-diameter same-material parallel plate of a dynamic viscoelasticity measuring device RS6000 (RheoStress RS6000), left in a 1 Hz oscillation mode at 25°C for 60 seconds; and thereafter, the viscosity variation was evaluated when the shear stress was varied from 0.001 Pa to 1.0E+4 Pa.

The case where the difference between the maximum value and the minimum value of the viscosity in the shear stress application was higher than 100 Pa was taken as ×; higher than 50 Pa and 100 Pa or lower, as Δ; 50 Pa or lower and higher than 20 Pa, as ○; and 20 Pa or lower, as ◎.

<Evaluation results>

From the above results indicated in Table 1, it was recognized that the curable resin compositions of Examples 1 to 6, which contained predetermined components defined in the present invention and had an evaluation of the viscosity-3 of 20 Pa or lower, were excellent in the bubble escaping property and were excellent also in the finger touch dryability, the electroless gold platability, the solder heat resistance, the flexibility, the bendability, the flame retardancy and the electric property.

By contrast, it was recognized that Comparative Examples 1 and 2 were inferior not only in the bubble escaping property, but inferior also in the finger touch dryability, the electroless gold platability, the solder heat resistance, the flexibility and the bendability.

## Claims

1. A curable resin composition, comprising:

   (A) an alkali-soluble resin;
   (B) a photopolymerization initiator;
   (C) a compound having a molecular weight of 300 to 1,000 and two ethylenically unsaturated groups; and
   (D) a thermosetting component,

   wherein a viscosity variation of the curable resin composition is not more than 20 Pa when measured with 0.2 ml of the curable resin composition being interposed between two stainless steel sensor plates of 35 mm in diameter and being left at 25°C for 60 seconds, followed by application of a shear stress thereto, the shear stress being varied from 0.0001 Pa to 1.0E+4 Pa.

2. The curable resin composition according to claim 1, wherein the (D) thermosetting component comprises a crystalline epoxy resin.

3. The curable resin composition according to claim 2, wherein the (D) thermosetting component further comprises a noncrystalline epoxy resin.

4. The curable resin composition according to any one of claims 1 to 3, wherein the (C) compound having a molecular weight of 300 to 1,000 and two ethylenically unsaturated groups has a viscosity of 15 to 200 mPa·s at 25°C.

5. The curable resin composition according to any one of claims 1 to 4, wherein the content of the (C) compound having a molecular weight of 300 to 1,000 and two ethylenically unsaturated groups is, in terms of solid content, 5 to 40 parts by mass with respect to 100 parts by mass of the (A) alkali-soluble resin.

6. The curable resin composition according to any one of claims 1 to 5, wherein the curable resin composition is used for production of a printed wiring board with a high-voltage circuit.

7. A dry film, comprising a resin layer prepared by applying the curable resin composition according to any one of claims 1 to 6 on a film and drying the curable resin composition.

8. A cured material, obtained by curing the curable resin composition according to any one of claims 1 to 6 or the dry film according to claim 7.

9. An electronic component, comprising the cured material according to claim 8.

# EP 3 901 699 A1

<table>
<tr><td colspan="2"><b>INTERNATIONAL SEARCH REPORT</b></td><td>International application No.<br>PCT/JP2019/040684</td></tr>
</table>

**A. CLASSIFICATION OF SUBJECT MATTER**
Int.Cl. G03F7/027(2006.01)i, C08F2/44(2006.01)i, C08F2/50(2006.01)i,
G03F7/004(2006.01)i, H05K3/28(2006.01)i

According to International Patent Classification (IPC) or to both national classification and IPC

**B. FIELDS SEARCHED**

Minimum documentation searched (classification system followed by classification symbols)
Int.Cl. G03F7/027, C08F2/44, C08F2/50, G03F7/004, H05K3/28

Documentation searched other than minimum documentation to the extent that such documents are included in the fields searched
Published examined utility model applications of Japan      1922-1996
Published unexamined utility model applications of Japan      1971-2019
Registered utility model specifications of Japan      1996-2019
Published registered utility model applications of Japan      1994-2019

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2011-048313 A (HITACHI CHEMICAL CO., LTD.) 10 March 2011, paragraphs [0001], [0078], [0118]–[0122], [0125], example 2 (Family: none) | 1-9 |
| X<br>A | JP 2011-185962 A (ASAHI KASEI E MATERIALS CORPORATION) 22 September 2011, paragraphs [0001]–[0006], [0048], [0049], comparative example 1 (Family: none) | 1-2, 4, 7-9<br>3, 5-6 |

☒ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>19.12.2019 | Date of mailing of the international search report<br>07.01.2020 |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

International application No.

PCT/JP2019/040684

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2011-215392 A (FUJIFILM CORPORATION) 27 October 2011, examples<br>& KR 10-2011-0109919 A & TW 201211691 A | 1, 3-4, 6-9<br>2, 5 |
| A | JP 2018-077490 A (ASAHI KASEI CORPORATION) 17 May 2018, examples<br>& US 2017/0285474 A1, examples & WO 2016/047691 A1<br>& TW 201619705 A & KR 10-2017-0032364 A & CN 107077067 A | 1-9 |
| A | JP 2005-331966 A (E. I. DU PONT DE NEMOURS AND COMPANY) 02 December 2005, claim 1<br>& US 2001/0051689 A1, claim 1 & WO 1999/045045 A1<br>& TW 593458 B & CN 1292804 A & KR 10-0397715 B | 1-9 |
| A | KR 10-2009-0072177 A (DOOSAN CORPORATION) 02 July 2009, claim 1<br>(Family: none) | 1-9 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014156583 A